# EUROPÄISCHE PATENTSCHRIFT

(11) **EP 1 230 127 B1**
(45) Veröffentlichungstag und Bekanntmachung des Hinweises auf die Patenterteilung: **26.01.2005**
(21) Anmeldenummer: 00987159.1
(22) Anmeldetag: 16.11.2000
(51) Int. Cl.: B65B 69/00, H05K 13/04

(54) **VERFAHREN UND VORRICHTUNG ZUM ABZIEHEN DER DECKFOLIE VON BAUELEMENT-GURTEN**
METHOD AND DEVICE FOR PEELING THE COVERING FOIL FROM COMPONENT TAPES
PROCEDE ET DISPOSITIF POUR RETIRER UNE FEUILLE DE RECOUVREMENT D'UNE COURROIE TRANSPORTEUSE DE COMPOSANTS

(30) Priorität: 18.11.1999 DE 19955597
(43) Veröffentlichungstag der Anmeldung: 14.08.2002
(73) Patentinhaber: Siemens Aktiengesellschaft, 80333 München (DE)
(72) Erfinder: LIEBEKE, Thomas, 83059 Kolbermoor (DE)
(74) Vertreter: Berg, Peter, Dipl.-Ing.
(86) Internationale Anmeldenummer: PCT/DE2000/004067
(87) Internationale Veröffentlichungsnummer: WO 2001/036273

(56) Entgegenhaltungen:
- US-A- 4 327 482
- US-A- 4 738 386
- US-A- 4 943 342
- US-A- 5 191 693
- US-A- 5 213 653
- US-A- 5 310 301

## Beschreibung

Die Erfindung bezieht sich auf eine Zuführeinrichtung gemäß dem Oberbegriff des Patentanspruchs 1.

Bei der automatischen Bestückung von Leiterplatten mit oberflächenmontierbaren Bauelementen, den sogenannten SMD-Bauelementen, erfolgt die Bereitstellung der Bauelemente über verschiedene Arten von Zuführeinrichtungen, wobei allerdings der Bereitstellung von gegurteten Bauelementen besondere Bedeutung zukommt. Die Anlieferform im Gurt ist besonders automatisierungsfreundlich, da die Bauelemente bereits vereinzelt sind und die Verpackung im Gurt weitgehende Sicherheit gegenüber Vertauschung gewährleistet. Die Bauelemente-Gurte werden von einer Gurtspule abgespult und einer Entnahmeposition für die Bauelemente zugeführt. Noch vor Erreichen dieser Entnahmeposition muß jedoch die Deckfolie der Bauelemente-Gurte abgezogen werden, beispielsweise über eine angetriebene Aufnahmespule für die Deckfolie, wie sie beispielsweise aus DE 40 21 101 oder aus EP 0 443 502 bekannt ist. Eine solche angetriebene Aufnahmespule weist allerdings den Nachteil auf, daß während des Leerens einer Aufnahmespule keine Zuführung von Bauelementen an dieser Zuführeinrichtung möglich ist. Da die Aufnahmespule entweder von der Deckfolie getrennt zu entsorgen ist, bzw. weiterverwendet werden soll, muß zusätzlicher Aufwand betrieben werden, um die Deckfolie von der Aufnahmespule zu entfernen.

Aus DE 35 44 221 ist eine Bandabziehmechanik bekannt, bei der das Deckband abgezogen wird, indem es zwischen einer angetriebenen ersten Rolle und einer gegen die Rolle gepreßten zweiten Rolle geführt wird. Über die anschließende Behandlung des Deckbandes wird nichts offenbart.

Aus DE 41 37 191 A1 ist eine Einrichtung zur Bereitstellung von gegurteten Bauelementen bekannt, bei der die abgezogene Deckfolie zwischen zwei angetriebene Räder hindurchgepreßt und anschließend in einen Behälter gepreßt wird. Die im allgemeinen klebrige Deckfolie führt im Behälter allerdings zu Verunreinigungen, die dazu führen, daß sich nach einiger Zeit die Deckfolie an die Behälterinnenwände anlegt und ein weiteres Stopfen verhindert und die Leerung des Behälters erschwert.

Es ist daher die Aufgabe der Erfindung eine Zuführeinrichtung anzugeben, welche ein einfacheres Entsorgen der Deckfolie auch während des Betriebs der Zuführeinrichtung ermöglicht.

Die Aufgabe wird erfindungsgemäß gelöst durch eine Zuführeinrichtung der eingangs genannten Art mit den kennzeichnenden Merkmalen des Patentanspruchs 1.

Dabei ist zusätzlich zu den beiden Abzugsrollen, die für das Abziehen der Deckfolie vom Bauelemente-Gurt sorgen, eine weitere, sich angetrieben drehende Aufwickelrolle vorgesehen, auf die die durch den Zwischenraum der beiden Abzugsrollen hindurchgeführte Deckfolie aufgewickelt wird. Ist nun die Aufwickelrolle voll, kann sie gewechselt werden, ohne die erste Antriebsvorrichtung abzuschalten.

In einer vorteilhaften Ausgestaltung nach Anspruch 2, weist die Zuführeinrichtung eine separate zweite Antriebsvorrichtung für die Abwickelrolle auf, die unabhängig von der ersten Antriebsvorrichtung für die Abzugsrollen arbeitet. Durch die unabhängige Drehung der Abzugs- und Aufwickelrollen wird somit der Wechsel der Aufwickelrollen weiter vereinfacht.

Eine besonders kostengünstige Ausgestaltung der Zuführeinrichtung ergibt sich nach Anspruch 3 durch die Verwendung der ersten Antriebsvorrichtung auch zum Antreiben der Drehung der Aufwickelrolle. Auch in diesem Fall läßt sich bei weiter laufendem Antrieb die Aufwickelrolle wechseln, ohne daß die Abzugsrollen abgeschaltet und somit der Bestückvorgang unterbrochen wird.

Besonders vorteilhaft ist die Ausgestaltung der Zuführeinrichtung nach Anspruch 4, da durch die Ausführung der Aufwikkelrolle aus einem Kunststoff, eine gemeinsame Entsorgung mit der Deckfolie ermöglicht wird, die ebenfalls aus Kunststoff besteht, womit die aufwendige Arbeit des Entfernens der Deckfolie von der Aufwickelrolle vermieden wird.

Ebenfalls vorteilhaft ist die Ausgestaltung der Zuführeinrichtung aus Pappe oder Papier nach Anspruch 5, da diese dann ebenfalls mit der Deckfolie zusammen entsorgt wird.

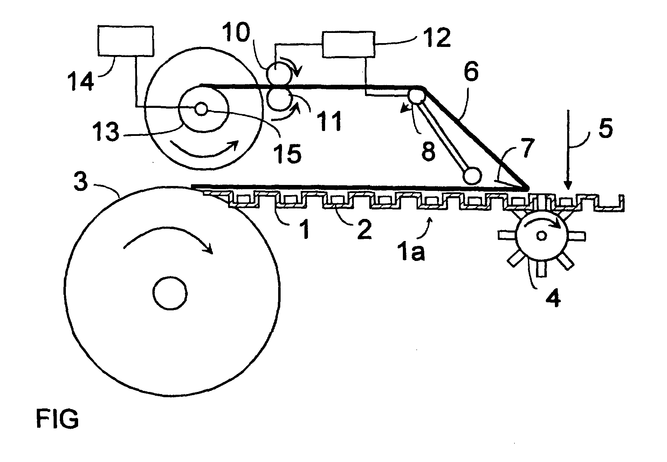

Die Erfindung wird nun anhand eines Ausführungsbeispiels in der einzigen Figur der Zeichnung näher erläutert.

Dabei zeigt die Figur eine schematische Seitenansicht einer erfindungsgemäßen Zuführeinrichtung, die eine erfindungsgemäße Abzugsvorrichtung umfaßt.

In der Figur ist schematisch ein Bauelemente-Gurt 1 dargestellt, in dessen Taschen 1a die Bauelemente 2 eingelagert sind. Die Bauelemente-Gurte werden in der Regel in Form von Vorratsrollen 3 angeliefert, die in die Zuführeinrichtungen einlegbar sind. Mithilfe eines angetriebenen Stachelrades 4 welches in nicht näher dargestellte Perforationen des Bauelemente-Gurtes 1 eingreift, werden die Bauelemente 2 in den Taschen 1a des Bauelemente-Gurtes 1 bis zu einer Entnahmeposition 5 transportiert. An dieser Entnahmeposition 5 werden die Bauelemente 2 dann beispielsweise von einem Bestückkopf entnommen und in einer vorgegeben Position auf eine Leiterplatte oder ein Keramiksubstrat aufgesetzt.

Damit die Bauelemente 2 nicht aus dem Bauelemente-Gurt 1 herausfallen können, sind die Taschen 1a mit einer Deckfolie 6 abgedeckt, die vor dem Erreichen der Entnahmeposition 5 beispielsweise an einer Abzugskante 7 abgezogen wird. Die Kraft für den Abzug wird über eine erste Abzugsrolle 10 und eine zweite Abzugsrolle 11 auf die Deckfolie übertragen. Die beiden Abzugsrollen 10,11 werden dabei über eine erste Antriebsvorrichtung 12 angetrieben und drehen sich gegenläufig. Die Deckfolie 6 wird zwischen den beiden Abzugsrollen 10,11 hindurchgeführt bzw. hindurchgepreßt. Die erste Antriebsvorrichtung 12 kann dabei über eine sogenannte Folienschwinge 8 gesteuert werden, wie es in DE 40 21 101 detailliert beschrieben ist, damit die Abzugskraft immer optimal auf die Deckfolie 6 wirkt. Die Folienschwinge 8 ist dafür über eine nicht dargestellte Feder mit einem Schaltorgan der ersten Antriebsvorrichtung 12 gekoppelt und schaltet die erste Antriebsvorrichtung 12 je nach anliegender Federspannung ein und aus. Dadurch ist sichergestellt, daß bei Zuführeinrichtungen, die momentan keine Bauelemente 2 zu liefern haben, auch die Deckfolie 6 nicht abgezogen wird und womöglich durch die Abzugskraft der Bauelemente-Gurt 1 verrutscht.

Nach dem Hindurchpressen der Deckfolie 6 wird diese auf eine Aufwickelrolle 13 aufgewickelt, die in vorteilhafter Weise aus Pappe oder Papier bzw. aus einem Kunststoff gefertigt ist, der die gleichen Bestandteile aufweist wie die Deckfolie 6. In diesem Fall kann die Aufwickelrolle 13 zusammen mit der aufgewickelten Deckfolie 6 entsorgt werden und das aufwendige Abwickeln der Deckfolie 6 von der Aufwickelrolle 13 entfällt.

Die Aufwickelrolle 13 wird beispielsweise von einer separaten Antriebsvorrichtung 14 gedreht, welche einen Stift 15 dreht, auf den die Aufwickelrolle 13 in Richtung ihrer Drehachse aufgesteckt ist. Somit können sich die beiden Abzugsrollen 10,11 weiterdrehen, wenn die Aufwickelrolle 13 gewechselt wird weil auf dieser keine weitere Deckfolie 6 aufgewickelt werden kann. Dazu wird die Aufwickelrolle 13 vom Stift 15 abgezogen und eine neue Aufwickelrolle 13 aufgesteckt auf den Stift 15 aufgesteckt. Dadurch ist sichergestellt, daß diese Zuführeinrichtung auch während des Entsorgens der Deckfolie 6 weiterbetrieben wird und nicht angehalten werden muß. Außer der Kopplung über einen Stift 15 sind natürlich auch andere Kopplungen vorstellbar, wie beispielsweise Befestigen an ein drehendes Rad, um die Drehung auf die Aufwickelrolle 13 zu übertragen.

Auch bei der - nicht dargestellten - Verwendung der ersten Antriebsvorrichtung 12 zum Drehen der Aufwickelrolle 13 läßt sich die Aufwickelrolle 13 wechseln, ohne die Abzugsrollen 10,11 anzuhalten und somit den Bestückvorgang zu unterbrechen. Dabei ist dann allerdings sicherzustellen, daß das Wechseln der Aufwickelrolle 13 keine Störung der ersten Antriebsvorrichtung 12 hervorruft, was beispielsweise durch das Aufstecken der Drehachse der Aufwickelrolle 13 auf einen von der ersten Antriebsvorrichtung 12 angetriebenen Stift 15 ermöglicht wird, von dem die Aufwickelrolle 13 leicht wieder abgenommen werden kann.

## Patentansprüche

1. Zuführeinrichtung für gegurtete Bauelemente (2)
mit einer Transportvorrichtung (4) für einen Bauelemente-Gurt (1) mit einer Abzugsvorrichtung für die Deckfolie des Bauelemente-Gurtes (1),
wobei die Abzugseinrichtung eine erste (10) und eine zweite (11) benachbart angeordnete, sich gegenläufig zueinander drehende Abzugsrolle, zwischen denen die abgezogene Deckfolie (6) hindurchführbar ist, vorgesehen sind und
wobei eine erste Antriebsvorrichtung zum Drehen mindestens einer der beiden Abzugsrollen (10, 11) vorgesehen ist.
**dadurch gekennzeichnet,**
**dass** die Zuführeinrichtung eine sich angetrieben drehende Aufwickelrolle (13) aufweist, auf der die Deckfolie (6) aufwickelbar ist und
**dass** die Abzugsrollen (10, 11) vor der Aufwickelrolle (13) angeordnet sind.

2. Zuführeinrichtung nach Anspruch 1,
**dadurch gekennzeichnet,**
**daß** eine zweite Antriebsvorrichtung (14) zum Antreiben der Aufwickelrolle (13) vorgesehen ist.

3. Zufüreinrichtung nach Anspruch 1,
**dadurch gekennzeichnet,**
**daß** die erste Antriebsvorrichtung (12) so ausgebildet ist, daß diese auch die Aufwickelrolle (13) antreibt.

4. zuführeinrichtung nach einem der Ansprüche 1, 2 oder 3,
**dadurch gekennzeichnet,**
**daß** die Aufwickelrolle (13) aus einem Kunststoff hergestellt ist.

5. Zuführeinrichtung nach einem der Ansprüche 1, 2 oder 3,
**dadurch gekennzeichnet,**
**daß** die Aufwickelrolle (3) aus Papier oder Pappe hergestellt ist.

## Claims

1. A feed apparatus for taped components (2)
with a transport device (4) for a component tape (1) with a peeling device for the cover tape of the component tape (1),
where a first (10) and a second (11) peeling roller arranged adjacent and rotating in opposite directions with respect to each other are provided for the peeling apparatus, between which the peeled-off cover tape (6) can be guided through, and
where a first drive device is provided for turning at least one of the two peeling rollers (10, 11),
**characterized by the fact**
that the feed apparatus displays a driven rotating take-up roller (13) on which the cover tape (6) can be wound, and
that the peeling rollers (10, 11) are arranged in front of the take-up roller (13).

2. A feed apparatus as claimed in Claim 1,
**characterized in that**
a second drive device (14) is provided for driving the take-up roller (13).

3. A feed apparatus as claimed in Claim 1,
**characterized in that**
the first drive device (12) is designed in such a way that it also drives the take-up roller (13).

4. A feed apparatus as claimed in one of Claims 1, 2 or 3,
**characterized in that**
the take-up roller (13) is manufactured out of a plastic material.

5. A feed apparatus as claimed in one of Claims 1, 2 or 3,
**characterized in that**
the take-up roller (3) is manufactured out of paper or cardboard.

## Revendications

1. Dispositif d'alimentation de composants (2) sur courroie transporteuse,
avec un dispositif de transport (4) pour une courroie transporteuse de composants (1), avec un dispositif de retrait du film de recouvrement de la courroie transporteuse de composants (1),
des premier (10) et second (11) rouleaux de retrait voisins, tournant à contresens, entre lesquels la feuille de recouvrement (6) retirée peut être guidée, étant prévus dans le dispositif de retrait et
un premier dispositif d'entraînement étant prévu pour mettre en rotation au moins l'un des deux rouleaux de retrait (10, 11 ),
**caractérisé en ce que**
le dispositif d'alimentation est muni d'un rouleau d'enroulement (13) entraîné en rotation, sur lequel la feuille de recouvrement (6) peut être enroulée et
**en ce que** les rouleaux de retrait (10, 11) sont disposés à l'avant du rouleau d'enroulement (13).

2. Dispositif d'alimentation selon la revendication 1,
**caractérisé en ce**
**qu'**un second dispositif d'entraînement (14) est prévu pour entraîner le rouleau d'enroulement (13).

3. Dispositif d'alimentation selon la revendication 1,
**caractérisé en ce**
**que** le premier dispositif d'entraînement (12) est conçu de façon à entraîner également le rouleau d'enroulement (13).

4. Dispositif d'alimentation selon l'une quelconque des revendications 1, 2 ou 3,
**caractérisé en ce**
**que** le rouleau d'enroulement (13) est fabriqué dans une matière plastique.

5. Dispositif d'alimentation selon l'une quelconque des revendications 1, 2 ou 3,
**caractérisé en ce**
**que** le rouleau d'enroulement (3) est fabriqué en papier ou en carton.
